# EUROPEAN PATENT APPLICATION

(11) **EP 3 487 074 A1**
(43) Date of publication of application: **22.05.2019**
(21) Application number: 17460067.6
(22) Date of filing: 20.11.2017
(51) Int. Cl.: H03K 17/0412, H03K 17/78, H03K 17/04

(54) **A PHOTOVOLTAIC CIRCUIT DRIVER FOR A SOLID STATE SWITCH**

(71) Applicant: ABB Schweiz AG, 5400 Baden (CH)
(72) Inventor: Jakubowski, Tomasz, 71-374 Szczecin (PL)
(74) Representative: Chochorowska-Winiarska, Krystyna

(57) **Abstract**

The present invention concerns a photovoltaic circuit driver for a solid state switch (3) for fast switching purposes. A circuit according to the invention comprises photovoltaic driver (1) with a light emitting diode (LED2), connected with a driving supply pulse circuit (B) for powering an energy into an array of the photodiodes (PD2), connected with a the driving-control pulse circuit (B') which is connected through a gate driver (2) with a solid state switch (3). The circuit also comprises a storage capacitor (C1) which is connected to the gate drive (2). The storage capacitor (C1) is connected directly to an array of the photodiodes (PD1) of photovoltaic driver (1) in which the array (PD1) is powered from a DC power supply circuit (A) through a light emitting diode (LED1) of the photovoltaic driver (1) and the light emitting diode (LED1) is connected with the DC power supply circuit (A) for powering an energy into an array of the photodiodes (PD1).

## Description

The present invention concerns a photovoltaic circuit driver for a solid state switch for fast switching purposes in the following applications: a semiconductor relay or an upper transistor's driver of half/full-bridge converter.
Typical solutions for energizing gate driver for a solid state switch are based on bootstrap circuit, or a collector-emitter voltage, or an insulated low-power converter, or a transformer (50Hz) power supply. The bootstrap circuit solution and the solution based on collector-emitter voltage store energy in capacitor in either on-state of lower transistor or off-state of related transistor in the half-bridge. As a result continuous transistor's switching is inevitable to have energy stored for next switching cycles. The other solutions based on insulated low-power converter or transformer-based (50Hz) require relatively large amount of board space.
Using photovoltaic driver for energizing transistor's gate for solid state switch seems to be very appealing. It converts electrical power to light power (LED diode) and back to electrical power (photovoltaic cell). This ensure electrical insulation. Output current is very low (∼50uA) thus direct energizing of transistor's gate generates a large gate voltage rise-time and solid state switch turn-on delay. This disadvantage cause the solution mentioned above inappropriate for fast switching purposes.

From utility model description DE19735583 there is known semiconductor switch that is energized by a photovoltaic driver (arrangement). The circuit comprises the photovoltaic circuit which is equipped with a LED for receiving light energy from an electric power circuit. The light emitted from LED is transferred into the array of the LED diodes which are working in photovoltaic mode and produced a photocurrent which is directed to the switch element thorough an electric circuit having a storage capacitor connected parallel with circuit decoder and a gate driver. A photo-sensor is connected to the circuit decoder. The circuit decoder, the gate driver and photo-sensor formed a control signal receiver. The control signal receiver couples the switch with a light source providing differently coded light signals for opening or closing the switch. The switching energy is stored in a capacitor connected to the array of the LED diodes. The first disadvantage of presented solution is that there is an additional switch-on and switch-off time delay which is introduced by decoder for decoding switch-on and switch-off command. The second disadvantage is that due to decoding process which is based on a square signal, the gate signal is synchronized with the square signal and a resolution of the signal depends on a frequency of the square signal.

**The essence of a photovoltaic circuit driver for a solid state switch according to the invention,** having a photovoltaic driver to which a driving-supply pulse circuit is connected, for supplying and controlling a gate driver for the solid state switch and having a storage capacitor, is that it the storage capacitor C1 is directly connected to the array of the photodiodes PD1 of the photovoltaic driver in which the array PD1 is powered from a DC power supply circuit through a light emitting diode LED1 of the photovoltaic driver. The DC power supply circuit is connected to a storing circuit which said storing circuit is connected with a gate driver directly and indirectly through a driving-control pulse circuit and a driving switching circuit with the solid state switch.
Preferably the storing circuit has a positive terminal for a directly connection with the array of photodiodes PD1 and with the gate driver and the storage capacitor C1. The storing circuit has a negative terminal for directly connection with the storage capacitor and the array of photodiodes PD1.
Preferably the photovoltaic driver has output terminals connected with the driving-control pulse circuit with the terminal connecting the storing circuit through the common negative terminal, connected with the storage capacitor.
Preferably in the driving-control pulse circuit between the output terminals of the photovoltaic driver at least one resistor is connected.
Preferably the solid state switch is connected to the driving-switching circuit which is equipped with at least one resistor connected in series with the gate driver.
Preferably the solid state switch is connected to the driving-switching circuit which is equipped with at least one resistor connected parallel with the gate driver.
Preferably the photovoltaic driver has a form of the two separated devices, the first one with the pair of input terminals for connecting the first DC power supply circuit and the pair of output terminals for connecting the storing circuit and the second one with the pair of input terminals for connecting the driving supply pulse circuit and with a pair of output terminals for connecting the driving-control pulse circuit.
Preferably the light emitting diode LED1 of the DC power supply circuit and the light emitting diode LED2 of the driving-supply pulse circuit are so selected that wavelengths of the emitted lights have the same values.
Preferably the gate driver has a form of MOSFET/IGBT driver, or complementary pair of a bipolar junction transistor BJT connected as half-bridge or combination of MOSFET/BJT transistor connected as half-bridge.
Preferably the solid state switch has a form of an IGBT transistor, or a MOSFET transistor or BIGT transistor.

The advantage of the present invention is that due to two separated photovoltaic circuits - a first one for supplying and storing energy and a second for **suppling and controlling stored** energy, make it possible to supply energy for switching process of solid state switch regardless of solid state switch state. Further the invention allows for speeding up gate charging of solid state switch and assures instantaneous control of solid state switch. There is no need for introducing a decoding circuit which introduced additional signal delay to the solid state switch.

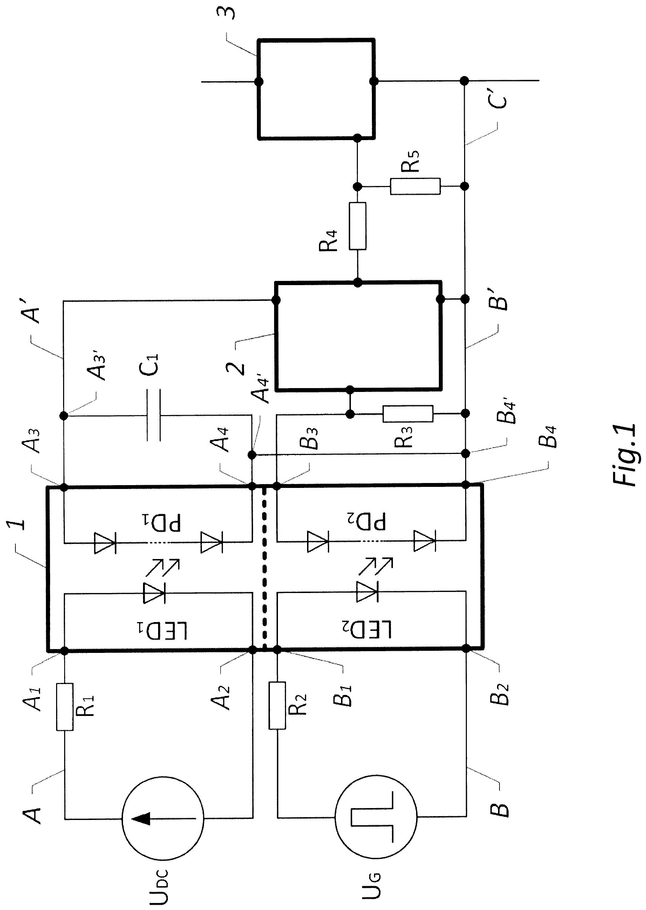

The invention is presented in the exemplary embodiment on the drawing where fig. 1 shows a circuit diagram of photovoltaic circuit driver for a solid state switch.

The a photovoltaic circuit driver comprises a photovoltaic driver 1 which is connected with two separated photovoltaic circuits - a first one being a DC power supply circuit A, for supplying energy from an electric DC power source U_{DC} and a second one being a driving-supply pulse circuit B, for supplying pulse energy from an electric pulse power source U_{G} for driving and control purpose. The DC power supply circuit A is equipped with a light emitting diode LED1 for converting an electrical energy from the DC power source U_{DC} to a light energy and is equipped with a resistance R1 connected in series with light emitting diode LED1. The photovoltaic driver 1 is connected to the DC power supply circuit A through input terminals A1 and A2. The photovoltaic driver 1 comprises a first photovoltaic array of photodiodes PD1 which is connected through output terminals A3 and A4 with a storing circuit A'. The driving-supply pulse circuit B is equipped with a light emitting diode LED2 for converting an electrical energy from the electric pulse power source U_{G} to a light energy and is equipped with a resistance R2 connected in series with light emitting diode LED2. The photovoltaic driver 1 is connected to the driving-supply pulse circuit B through input terminals B1 and B2. The photovoltaic driver 1 comprises a second photovoltaic array of photodiodes PD2 which is connected through output terminals B3 and B4 with a driving-control pulse circuit B'. Preferably the both light emitting diodes LED1 and LED2 have the same wavelength values of the emitted lights. The light energy emitted from light emitting diode LED1 is converted to the electrical energy by the array of photodiodes PD1 and is directed thorough output terminals A3 and A4 to the storing circuit A' having a storage capacitor C1, connected parallel to the array of photodiodes PD1 through terminal A3' and A4'. The light energy emitted from light emitting diode LED2 is converted to the electrical energy by the array of photovoltaic PD2 and is directed thorough output terminals B3 and B4 to the gate driver 2 through driving circuit B'. The gate driver 2 is connected with a solid state switch 3 through a driving-switching circuit C' and is connected with the storing circuit A' through the terminal B4' of the driving-control pulse circuit B' and through a terminal A4' of the storing circuit A' to storing capacitor C1. In the driving-control pulse circuit B' to the output terminals B3 and B4 at least one resistor R3 is connected parallel. The resistor R3 is also connected parallel with the gate driver 2. The resistor R3 pulls down input voltage of gate driver 2 and speeds up switch-off process of the solid state switch 3. The driving-switching circuit C' is equipped with at least one resistor R4 connected in series with the gate driver 2 and at least one resistor R5 connected parallel with the gate driver 2. Resistor R4 limits output current of the gate driver 2 in order to protect solid state switch 3 during the switching. Resistor R5 pulls down control voltage of the solid state switch 3 when it is in the off state. The presence of the storage capacitor C1 in the storing circuit A' and relation of the storage capacitor C1 with the driving-control pulse circuit B' allows for directing energy from the storage capacitor C1 to gate driver 2 during the operation switch-on of the solid state switch 3 or for discharging the solid state switch 3 during the switch-off operation. The photovoltaic driver 1 has a form of a one device having a pair of input terminals A1 and A2 for connecting the DC power supply circuit A and with a pair of output terminals A3 and A4 for connecting the storing circuit A' and having a pair of input terminals B1 and B3 for connecting the driving-supply pulse circuit B and with a pair of output terminals B3 and B4 for connecting the driving-control pulse circuit B'. The photovoltaic driver 1 may have a form of the two devices, one device with the pair of input terminals A1 and A2 for connecting the DC power supply circuit A and the pair of output terminals A3 and A4 for connecting the storing circuit A', and one device with the pair of input terminals B1 and B2 for connecting the driving-supply pulse circuit B and a pair of output terminals B3 and B4 for connecting the driving-control pulse circuit B', what is presented in the drawing by dashed line. The gate driver 2 has a form of typical MOSFET/IGBT driver, or complementary pair of BJT (Bipolar Junction Transistor) as half-bridge or combination of MOSFET/BJT transistor connected as half-bridge. The solid state switch 3 has a form of an IGBT transistor, or a MOSFET transistor or BIGT transistor.
The index of indication of circuits on the drawing
A - a DC power supply circuit
A' - a storing circuit
B - a driving-supply pulse circuit
B' - a driving-control pulse circuit
C' - a driving-switching circuit

## Claims

1. **A photovoltaic circuit driver for a solid state switch (3)** comprises photovoltaic driver (1) having a light emitting diode (LED2), connected with a driving-supply pulse circuit (B) for powering an energy into an array of the photodiodes (PD2), connected with a the driving-control pulse circuit (B') which is connected through a gate driver (2) with a solid state switch (3); having a storage capacitor (C1) which is connected with the gate driver (2), **characterized in that** the storage capacitor (C1) is directly connected to an array of the photodiodes (PD1) of photovoltaic driver (1) in which the array of the photodiodes (PD1) is powered from a DC power supply circuit (A) through a light emitting diode (LED1) of the photovoltaic driver (1) and the DC power supply circuit is connected to a storing circuit (A'), which is connected directly with the gate driver (2) and indirectly through a driving-control pulse circuit (B') and a driving-switching circuit (C') with the solid state switch (3).

2. A photovoltaic circuit according to claim 1, **characterized in that** the storing circuit (A') has a positive terminal (A3') for a directly connection with the array of photodiodes (PD1) and the gate driver (2) and the storage capacitor (C1), and the storing circuit (A') has a negative terminal (A4') for **directly** connection with the storage capacitor (C1) and the array of photodiodes (PD1).

3. A photovoltaic circuit according to claim 1, **characterized in that the** photovoltaic driver (1) has output terminals (B3, B4) connected with driving-control pulse circuit (B') with a terminal (B4') connecting the storing circuit (A') through a common negative terminal (A4') connected with the storage capacitor (C1).

4. A photovoltaic circuit according to claim 2, **characterized in that** in the driving-control pulse circuit (B') between the output terminals (B3, B4) of the photovoltaic driver (1) at least one resistor (R3) is connected.

5. A photovoltaic circuit according to claim 1, **characterized in that** the solid state switch (3) is connected to the driving-switching circuit (C') which is equipped with at least one resistor (R4) connected in series with the gate driver (2).

6. A photovoltaic circuit according to claim 4, **characterized in that** the driving-switching circuit (C') is equipped with at least one resistor (R5) connected parallel with the gate driver (2).

7. A photovoltaic circuit according to any previous claims, **characterized in that** the photovoltaic driver (1) has a form of the two separated devices, the first one with the pair of input terminals (A1, A2) for connecting the first DC power supply circuit (A) and the pair of output terminals (A3, A4) for connecting the storing circuit (A') and the second one with the pair of input terminals (B1, B2) for connecting the driving-supply pulse circuit (B) and with a pair of output terminals (B3, B4) for connecting the driving-control pulse circuit (B').

8. A photovoltaic circuit according to any previous claims, **characterized in that** the light emitting diode (LED1) of the DC power supply circuit (A) and the light emitting diode (LED2) of the driving-supply pulse circuit (B) are so selected that wavelengths of the emitted lights have the same values.

9. A photovoltaic circuit according to any previous claims, **characterized in that** gate driver (2) has a form of MOSFET/IGBT driver, or a complementary pair of bipolar junction transistor BJT connected as half-bridge or combination of MOSFET/BJT transistor connected as half-bridge.

10. A photovoltaic circuit according to any previous claims, **characterized in that** the solid state switch (3) has a form of an IGBT transistor, or a MOSFET transistor or BIGT transistor.
